# EUROPEAN PATENT APPLICATION

(11) **EP 1 536 482 A1**
(43) Date of publication of application: **01.06.2005**
(21) Application number: 04090476.5
(22) Date of filing: 29.11.2004
(51) Int. Cl.: H01L 29/786, H01L 29/423, H01L 21/336

(54) **Thin film transistor with tapered edges**

(30) Priority: 28.11.2003 KR 2003085848
(71) Applicant: Samsung SDI Co., Ltd., Suwon-si, Gyeonggi-do (KR)
(72) Inventor: Hwang, Eui-Hoon, c/o Samsung SDI Co., Ltd., Suwon-si Gyeonggi-do (KR); Lee, Sang-Gul, c/o Samsung SDI Co., Ltd., Suwon-si Gyeonggi-do (KR); Kim, Deuk-Jong, c/o Samsung SDI Co., Ltd., Suwon-si Gyeonggi-do (KR)
(74) Representative: Hengelhaupt, Jürgen, Dipl.-Ing.

(57) **Abstract**

A thin film transistor according to the present invention may include a gate insulating layer; and a lower pattern placed below the gate insulating layer to contact therewith and having an edge with a taper angle of at most about 80°. With this design, dielectric strength of the gate insulating layer can be enhanced. The lower pattern can be a gate electrode layer.

## Description

### CROSS-REFERENCE TO RELATED APPLICATION

This application claims the benefit of Korean Patent Application No. 2003-85848, filed November 28, 2003, the disclosure of which is incorporated herein by reference in its entirety.

### BACKGROUND OF THE INVENTION

### 1. Field of the Invention

The present invention relates to a thin film transistor and, more particularly, to a thin film transistor with improved dielectric strength in a gate insulating layer.

### 2. Description of the Related Art

Generally, a thin film transistor includes a semiconductor layer, a gate electrode, source/drain electrodes and a gate insulating layer interposed between the semiconductor layer and the gate electrode. For a circuit using the thin film transistor, there is a need to reduce the threshold voltage of the thin film transistor in order to implement high-speed operation. The threshold voltage of the thin film transistor has a close relationship with the thickness of the gate insulating layer, thus the gate insulating layer should be thinner to reduce the threshold voltage.

However, as the gate insulating layer becomes thinner, the dielectric strength of the gate insulating layer may deteriorate. The dielectric strength of the gate insulating layer refers to the maximum electric field that the gate insulating layer can withstand without breakdown. When the dielectric strength of the gate insulating layer is lower than a design value, breakdown may occur. This may cause operational defects in the performance of the thin film transistor, and a corresponding display defect in a display device using the thin film transistor.

To improve the dielectric strength properties of the gate insulating layer, Korean Patent Application No.1994-035626 discloses a method of depositing an oxide layer by low temperature CVD and then performing heat-oxidization. However, heat-oxidization in such a case requires a high temperature, thus disadvantageously requiring an expensive quartz substrate.

### SUMMARY OF THE INVENTION

The present invention provides a thin film transistor with improved dielectric strength of a gate insulating layer.

The thin film transistor may include a gate insulating layer and a lower pattern placed below the gate insulating layer in contact therewith and having an edge with a taper angle of 80° or less.

Preferably, the taper of the edge of the lower pattern may have an angle of at least 30°. More preferably, the taper of the edge of the lower pattern may have an angle of 60° to 75°.

It may be preferable that the gate insulating layer be made of a silicon oxide layer. Further, it may be preferable that the gate insulating layer be formed by plasma enhanced chemical vapor deposition (PECVD).

The lower pattern can be a semiconductor layer. Alternatively, the lower pattern can be a gate electrode. Here, it may be preferable that the gate electrode has a thickness of between about 500 and about 3000 A.

### BRIEF DESCRIPTION OF THE DRAWINGS

FIG. 1 is a plan view showing a typical top-gate thin film transistor.

FIGs. 2A and 2B are cross-sectional views for illustrating a top-gate thin film transistor during fabrication according to an embodiment of the present invention taken along the lines I-I' and II-II' of FIG. 1, respectively.

FIG. 3 is a cross-sectional view for illustrating a bottom-gate thin film transistor and method of fabricating the same according to another embodiment of the present invention.

FIGs. 4A, 5A, 6A, and 7A are pictures showing an edge of a semiconductor layer of a thin film transistor according to examples 1 and 2 and comparative examples 1 and 2, respectively.

FIGs. 4B, 5B, 6B and 7B are graphs showing dielectric strength properties of a gate insulating layer in a thin film transistor according to examples 1 and 2 and comparative examples 1 and 2, respectively.

### DETAILED DESCRIPTION OF THE INVENTION

The present invention will now be described more fully with reference to the accompanying drawings, in which preferred embodiments of the invention are shown. This invention may, however, be embodied in different forms and should not be construed as limited to the embodiments set forth herein. In the drawings, the thickness of layers and regions are exaggerated for clarity. Like numbers refer to like elements throughout the specification.

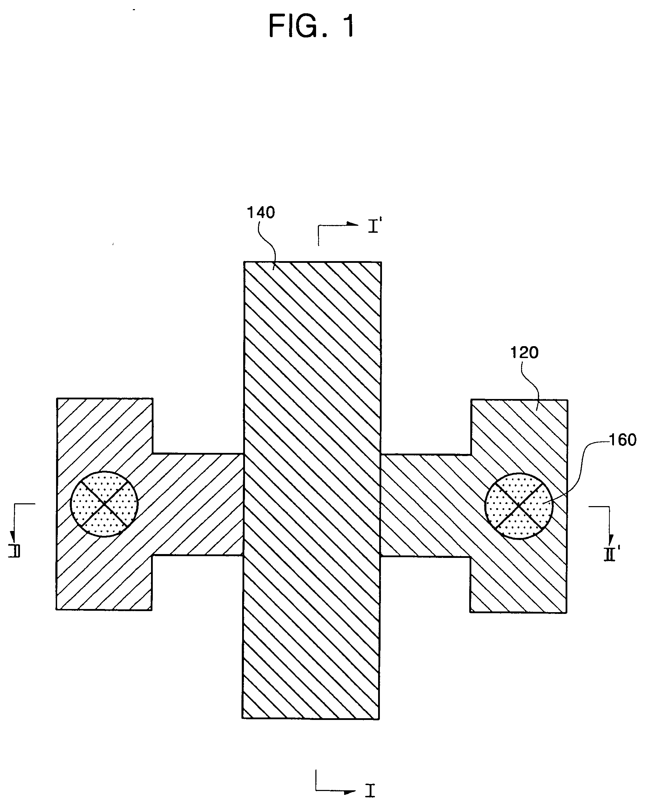

As shown in FIG. 1, a semiconductor layer 120 may be placed in one direction, and a gate electrode 140 crossing the semiconductor layer 120 may be placed on the semiconductor layer 120. A gate insulating layer (not shown) may be placed between the semiconductor layer 120 and the gate electrode 140. Source/drain electrodes 160 may be located on both ends of the semiconductor layer 120.

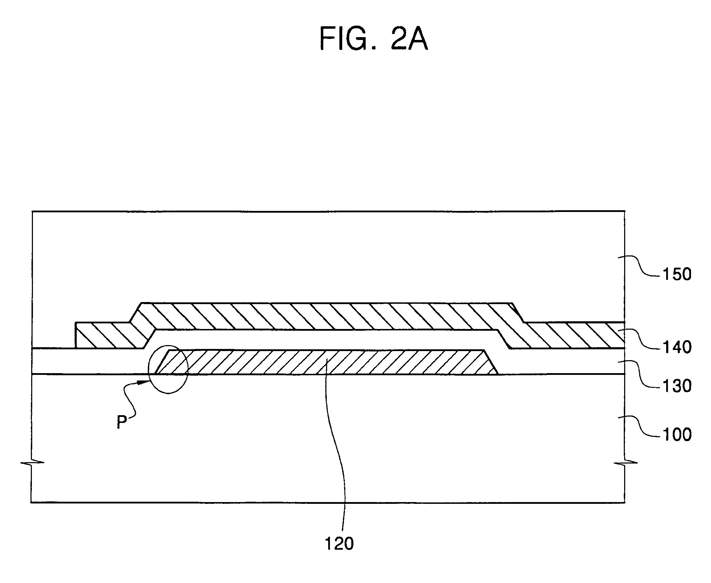

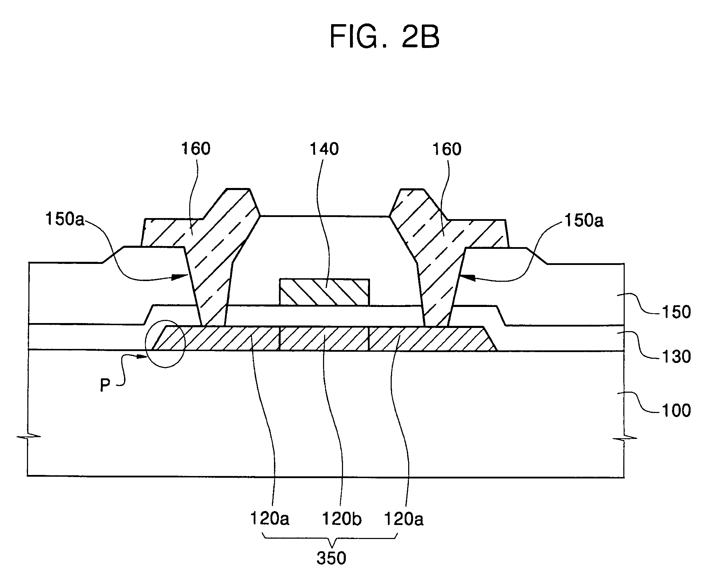

As shown in FIGs. 2A and 2B, a substrate 100 may be provided, and preferably, a buffer layer (not shown) may be formed on the substrate 100. The buffer layer may protect the active portions of the thin film transistor from impurities emitted from the substrate 100 during subsequent processing. The buffer layer can be formed of, for example, a silicon oxide layer, a silicon nitride layer, a silicon oxynitride layer, or a stacked layer thereof. Preferably, after an amorphous layer is formed on the buffer layer, the amorphous layer may be crystallized by excimer laser annealing (ELA), sequential lateral solidification (SLS), metal induced crystallization (MIC), metal induced lateral crystallization (MILC), or the like. Such a method may form a polysilicon layer. It may be preferable that the polysilicon is between about 300 and about 1000Å thick.

Next, a photoresist pattern may be formed on the polysilicon layer, and (using the photoresist pattern as a mask) the polysilicon layer may be etched to form a semiconductor layer 120. The semiconductor layer 120 may be formed to have a tapered edge, wherein the taper of the edge may have an angle of 80° or less. Preferably, the etching of the polysilicon layer may be performed by dry etching, which has an excellent etch uniformity and a low etch CD loss. Further, it may be preferable that the semiconductor layer 120 having the tapered edge may be formed using a mixed gas of O₂ and SF₆ as an etch gas. The O₂ may serve to etch the side of the photoresist pattern as the SF₆ etches the silicon. This may accordingly permit the semiconductor layer 120 to be formed with a tapered edge. The taper angle of the edge in the semiconductor layer 120 can be adjusted by the flow rate/volume ratio of the O₂ and the SF₆.

Next, a gate insulating layer 130 that covers the semiconductor layer 120 may be formed on the semiconductor layer 120. The gate insulating layer 130 can be formed of, for example, a silicon oxide layer or a silicon nitride layer. However, it may be preferable that the gate insulating layer 130 be formed of a silicon oxide layer, because of its good dielectric strength. Preferably, the gate insulating layer 130 is formed by low temperature PECVD, although other techniques may be used.

The semiconductor layer 120 may be formed to have a tapered edge of 80° or less. This choice of taper angles may help to prevent the phenomenon in which a deposited gate insulating layer 130 becomes thinner at the sides of the semiconductor layer 120. When the gate insulating layer 130 becomes thinner at the side of the semiconductor layer 120, the gate insulating layer 130 can exhibit dielectric breakdown where it is thin. Consequently, the semiconductor layer 120 may be formed to have a tapered edge of 80° or less, and the gate insulating layer 130 can be uniformly formed on the top and side of the semiconductor layer 120. Therefore, the dielectric strength of the gate insulating layer 130 can be improved.

It may be preferable that the taper angle of the edge in the semiconductor layer 120 be about 30° or greater. When the taper angle is less than about 30°, the resistance of the semiconductor 120 may increase due to the thin edge below 30°. This can yield an increase in resistance of a channel formed in the semiconductor layer 120. More preferably, in order to balance the resistance properties and the dielectric strength properties, the taper angle of the edge in the semiconductor 120 may be between about 60° and about 75°.

Next, a gate electrode material may be deposited on the gate insulating layer 130, and may be patterned to form a gate electrode 140. Then impurities may be implanted into the semiconductor layer 120 using the gate electrode 140 as a mask. Thus, source/drain regions 120a may be formed in the semiconductor layer 120. A region between the source/drain regions 120a may define a channel region 120b.

Next, an interlayer 150 that covers the entire surface of the substrate having the gate electrode 140 may be formed, and source/drain contact holes 150a that each expose one of the source/drain regions 120a may be formed in the interlayer 150. Source/drain electrode materials may be deposited on the substrate where the source/drain contact holes 150a are formed. Patterned this way, source/drain electrodes 160 that respectively contact with the source/drain regions 120a through the source/drain contact holes 150a may be formed.

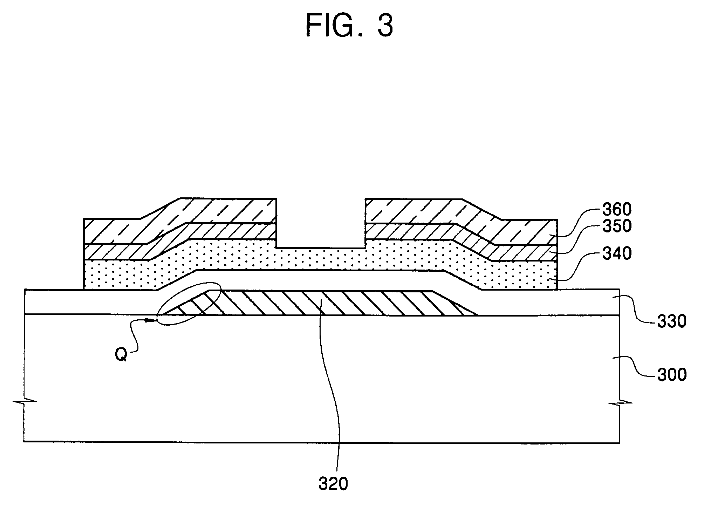

FIG. 3 is a cross-sectional view for illustrating a bottom-gate thin film transistor and a method for fabricating the same according to another embodiment of the present invention.

As shown in FIG. 3, a substrate 300 may be provided. A gate electrode material may be deposited on the substrate 300 and a photoresist pattern (not shown) may be formed on the deposited gate electrode material. Using the photoresist pattern as a mask, the gate electrode material may be etched to form a gate electrode 320. The gate electrode 320 may be formed to have a tapered edge with an angle of about 80° or less. Preferably, the etching of the gate electrode material may be performed by a dry etching method, with excellent etch uniformity and a low etch CD loss. Further, it may be preferable that a gate electrode 320 having a tapered edge be performed using a mixed gas of O₂ and SF₆ as an etch gas. As previously explained, the O₂ may serve to etch the side of the photoresist pattern. This may permit the layer to have a tapered edge. The taper angle of the edge in the gate electrode 320 can be adjusted by controlling the flow rate/volume ratio of the O₂ and the SF₆.

For a flat panel display, it may be preferable that the gate electrode 320 be between about 500 and about 3000A thick, when balancing resistance properties and etch CD loss of the gate wiring simultaneously formed with the gate electrode 320.

Further, a gate insulating layer 330 may be deposited on the gate electrode 320. The gate insulating layer 330 can be formed of, for example, a silicon oxide layer or a silicon nitride layer. Preferably, the gate insulating layer 330 may be formed using a silicon oxide layer. Further, it may be preferable that the gate insulating layer 330 be formed by a low temperature PECVD process, or another similar process.

The gate electrode 320 may be formed to have a tapered edge of about 80° or less. This may alleviate the problem of the gate insulating layer 330 becoming too thin at the edges of the gate electrode 320. When the gate insulating layer 330 becomes thinner at the side of the gate electrode 320, the gate insulating layer 330 can exhibit dielectric breakdown where it is thin. Consequently, the gate electrode 320 may have a tapered edge of 80° or less, so that the gate insulating layer 330 can be uniformly formed on the top and side of the gate electrode 320. Thus, the dielectric strength of the gate insulating layer 330 can be improved.

It may be preferable that the taper of the edge in the gate electrode 320 has an angle of 30° or more, for the same reasons as in the previous embodiment.

Next, a semiconductor layer and an ohmic contact layer may be sequentially formed on the gate insulating layer 330. Here, it may be preferable that the semiconductor layer be formed of amorphous silicon, and the ohmic contact layer may be a region of amorphous silicon where impurities are doped. However, after the semiconductor layer is formed of the amorphous silicon, it may be crystallized by ELA, SLS, MIC, MILC, or the like to form a polysilicon layer. The ohmic contact layer and the semiconductor layer may be sequentially patterned to form a semiconductor layer pattern 340 and an ohmic contact layer pattern 350. In this example, the semiconductor layer pattern 340 may be formed to cover the gate electrode 320.

Next, source/drain electrode materials may be deposited on the ohmic contact layer pattern 350, and may be patterned to form source/drain electrodes 360. In this example, the semiconductor layer pattern 340 may be exposed between the source/drain electrodes 360.

Some illustrative examples follow in order to further assist the reader's understanding of the present invention.

### <Example 1>

An amorphous silicon layer was formed on an insulating substrate, and was patterned to form a polysilicon layer to a thickness of 500Å. A photoresist pattern was formed on the polysilicon layer. The polysilicon layer was etched using the photoresist pattern as a mask to form the semiconductor layer. The polysilicon was etched using SF₆/O₂ gas with a ratio of 120/180sccm to form a semiconductor layer. Further, a silicon oxide layer was PECVD deposited to a thickness of 1000 A on the semiconductor layer to form a gate insulating layer. A gate electrode was formed on the gate insulating layer, thereby fabricating the example thin film transistor.

### <Example 2>

A thin film transistor, in this example, was fabricated in the same manner as the example 1 except that the polysilicon layer was etched using SF₆/O₂ gas with a ratio of 100/200sccm.

### <Comparative example 1>

A thin film transistor was fabricated in the same manner as the example 1 except that the polysilicon layer was etched using SF₆/O₂ gas with a ratio of 150/150sccm.

### < Comparative example 2>

A thin film transistor, in this comparative example, was fabricated in the same manner as the example 1 except that the polysilicon layer was etched using SF₆/O₂ gas with a ratio of 150/50 sccm.

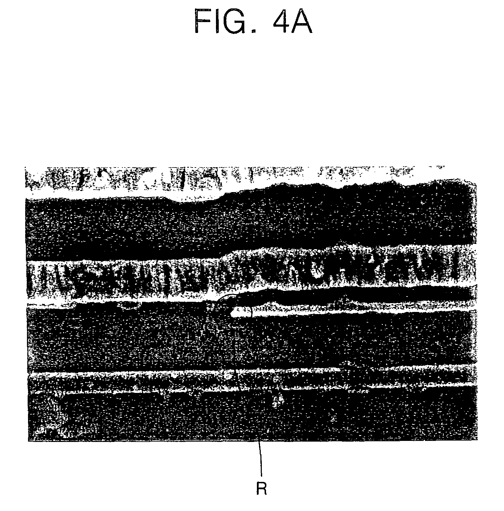

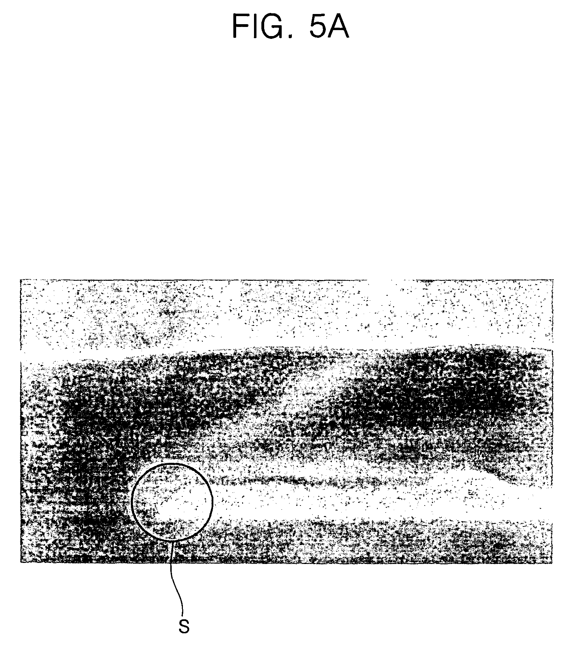

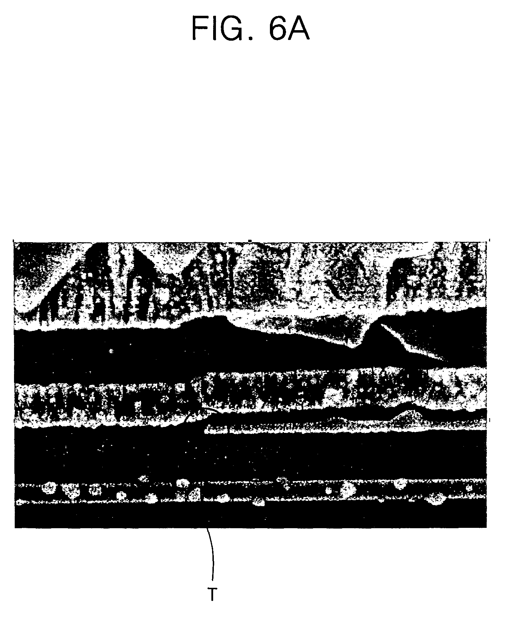

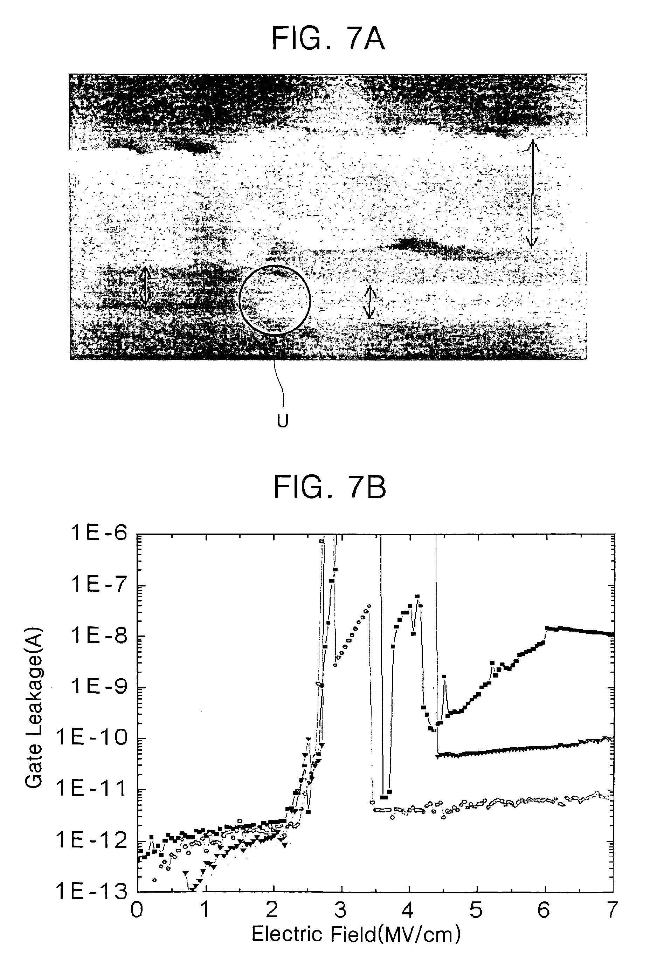

As shown in FIG. 4A, for the thin film transistor according to the example 1, the taper R of the edge in the semiconductor layer has an angle of about 78°. As shown in FIG. 5A, for the thin film transistor according to the example 2, the taper S of the edge in the semiconductor layer has an angle of about 60°. As shown in FIG. 6A, for the thin film transistor according to the comparative example 1, the taper T of the edge in the semiconductor layer has an angle of about 82°. As shown in FIG. 7A, for the thin film transistor according to the comparative example 2, the taper U of the edge in the semiconductor layer has an angle of about 90°.

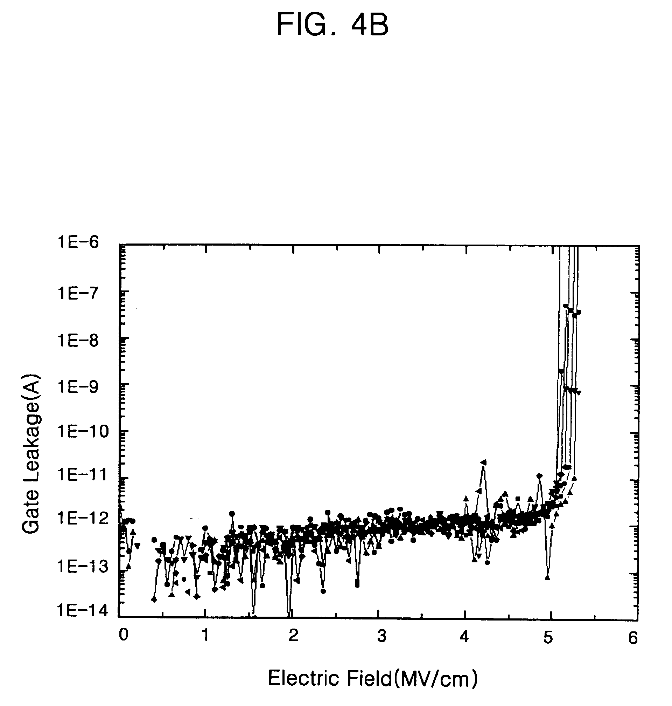

FIGs. 4B, 5B, 6B and 7B are graphs showing the dielectric strength of a gate insulating layer in a thin film transistor according to examples 1 and 2 and comparative examples 1 and 2, respectively. In the graphs, the X axis indicates the electric field (MV/cm) between the gate electrode and the semiconductor layer, and the Y axis indicates the leakage current (A) measured at the gate electrode.

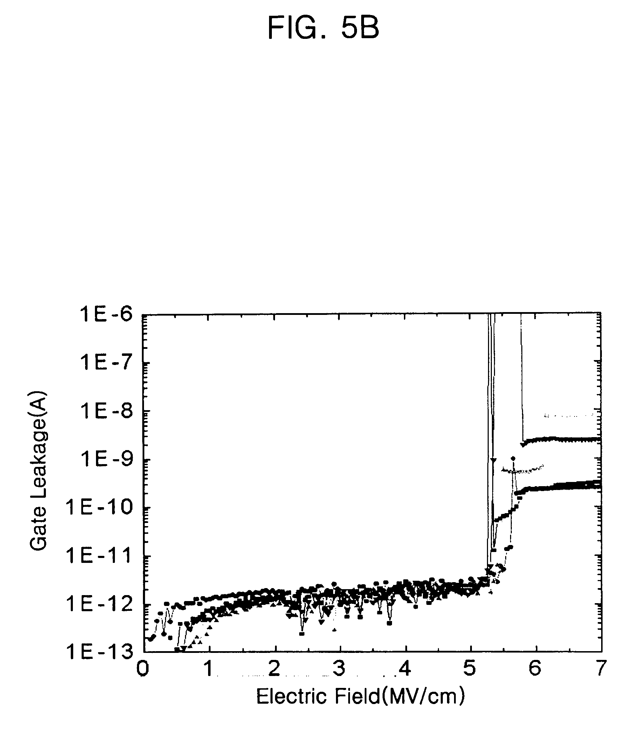

As shown in FIGs. 4B and 5B, for the thin film transistor according to the examples 1 and 2, the leakage current remains almost constant (at about 1x10⁻¹² A) until the electric field between the gate electrode and the semiconductor layer reaches about 5MV/cm. Thus, the dielectric strength of the gate insulating layer in the thin film transistor according to examples 1 and 2 is well enhanced.

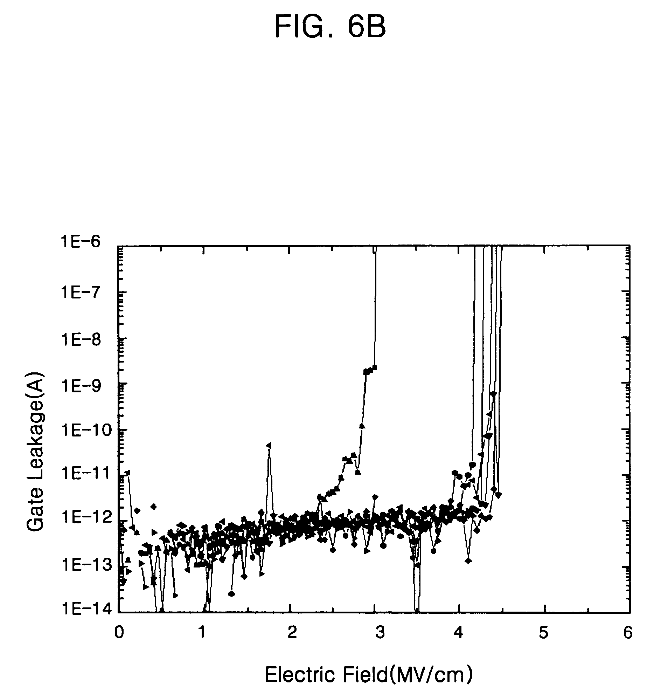

As shown in FIGs. 6B and 7B, for the thin film transistor according to the comparative examples 1 and 2, the gate leakage current shows a drastic increase when the electric field between the gate electrode and the semiconductor layer exceeds 2MV/cm. This indicates dielectric breakdown in the gate insulating layer. Such a breakdown can lead to a malfunction of the thin film transistor. It can also lead to a display defect in a display device that uses the thin film transistor. The likely defects under such circumstances may include a point defect, a line defect, or brightness nonuniformity.

As described above, according to the present invention, the lower pattern of the gate insulating layer may have an edge with a taper angle 80° or less, so that the dielectric strength of the gate insulating layer can be improved. Consequently, malfunction of the thin film transistor and (when the thin film transistor is employed in a display device) display defects can be prevented.

## Claims

1. A thin film transistor, comprising:
a gate insulating layer; and
a lower pattern located below and contacting the gate insulating layer and having an edge with a taper angle of up to about 80°.

2. The thin film transistor of claim 1, wherein the taper of the edge of the lower pattern has an angle of at least about 30°.

3. The thin film transistor of claim 1, wherein the taper of the edge of the lower pattern has an angle of about 60° to about 75°.

4. The thin film transistor of claim 1, wherein the gate insulating layer comprises a silicon oxide layer.

5. The thin film transistor of claim 1, wherein the gate insulating layer is formed by plasma enhanced chemical vapor deposition.

6. The thin film transistor of claim 1, wherein the lower pattern comprises a semiconductor layer.

7. The thin film transistor of claim 1, wherein the lower pattern comprises a gate electrode.

8. The thin film transistor of claim 7, wherein the gate electrode is about 500 Å to about 3000A thick.

9. A method for manufacturing a thin film transistor, comprising:
depositing a lower pattern on a substrate; and
depositing a gate insulating layer directly on the lower pattern,
wherein the lower pattern has an edge with a taper angle of up to about 80°.

10. The method of claim 9, wherein the taper of the edge of the lower pattern has an angle of at least about 30°.

11. The method of claim 9, wherein the taper of the edge of the lower pattern has an angle of about 60° to about 75°.

12. The method of claim 9, wherein the gate insulating layer comprises a silicon oxide layer.

13. The method of claim 9, further comprising forming the gate insulating layer by plasma enhanced chemical vapor deposition.

14. The method of claim 9, wherein the lower pattern comprises a semiconductor layer.

15. The method of claim 9, wherein the lower pattern comprises a gate electrode.

16. The method of claim 15, wherein the gate electrode is about 500 A to about 3000A thick.

17. A display device, comprising:
an array of a plurality of pixel electrodes,
wherein the plurality of pixel electrodes comprise thin film transistors, and
wherein the thin film transistors comprise:
a gate insulating layer; and
a lower pattern placed below the gate insulating layer to contact therewith and having an edge with a taper angle of up to about 80°.

18. The display device of claim 17, wherein the taper of the edge of the lower pattern has an angle of at least about 30°.

19. The display device of claim 17, wherein the taper of the edge of the lower pattern has an angle of about 60° to about 75°.

20. The display device of claim 17, wherein the lower pattern comprises a gate electrode.
